**Europäisches Patentamt**

**European Patent Office**

**Office européen des brevets**

(11) Numéro de publication : **0 186 567**
**B1**

(12) **FASCICULE DE BREVET EUROPÉEN**

(45) Date de publication du fascicule du brevet :
**07.06.89**

(51) Int. Cl.⁴ : **H 01 L 29/86**, H 01 L 29/91

(21) Numéro de dépôt : **85402434.6**

(22) Date de dépôt : **06.12.85**

(54) Diac à électrodes coplanaires.

(30) Priorité : **11.12.84 FR 8418926**

(43) Date de publication de la demande :
**02.07.86 Bulletin 86/27**

(45) Mention de la délivrance du brevet :
**07.06.89 Bulletin 89/23**

(84) Etats contractants désignés :
**CH DE FR GB IT LI**

(56) Documents cités :
**US–A– 4 216 488**

(73) Titulaire : **THOMSON-CSF**
**51, Esplanade du Général de Gaulle**
**F-92800 Puteaux (FR)**

(72) Inventeur : **Noguier, Jean-Pierre**
**THOMSON CSF SCPI 173, bld. Haussmann**
**F-75379 Paris Cedex 08 (FR)**
Inventeur : **Bacuvier, Pierre**
**THOMSON CSF SCPI 173, bld. Haussmann**
**F-75379 Paris Cedex 08 (FR)**

(74) Mandataire : **Rinuy, Santarelli**
**14, avenue de la Grande Armée**
**F-75017 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne les composants semiconducteurs connus sous le nom de diacs, qui sont des composants à deux bornes ayant des caractéristiques tension-courant à seuil telles que lorsque la tension aux bornes du diac croît en valeur absolue de zéro à une valeur de seuil, le diac reste bloqué et n'est parcouru que par un courant de fuite, puis, lorsque la tension dépasse le seuil, le diac conduit brusquement un courant important, la tension restant aux alentours de la valeur de seuil. Plus précisément, la caractéristique tension-courant du diac présente immédiatement au delà du seuil une partie à faible résistance dynamique négative qui est la cause d'un déclenchement très franc de la conduction du diac.

Un diac est réalisé habituellement sous la forme d'une structure tricouche NPN ou PNP dont la région centrale n'est pas reliée à une électrode ; ceci correspond essentiellement à un transistor à base ouverte. La construction est symétrique de manière que le diac fonctionne dans les deux sens d'application de tension.

Technologiquement, on réalise un diac en partant d'un substrat semiconducteur d'un premier type de conductivité, par exemple P ; on diffuse sur les deux faces une région surdopée P⁺ ; puis on diffuse sur les deux faces une région fortement dopée de type opposé. La structure résultante est symétrique, N⁺ P⁺ P P⁺ N⁺. Des électrodes sont déposées sur les deux faces principales.

Un inconvénient de cette structure est le fait que l'épaisseur du substrat semiconducteur de départ impose pratiquement la largeur de la base centrale (de type P pour une structure NPN), donc les caractéristiques de conduction du diac. On sera amené souvent à utiliser des substrats d'assez faible épaisseur, avec des risques de casse plus élevés durant la fabrication.

La présente invention propose une nouvelle structure de diac dans laquelle les régions extrêmes, métallisées, de la structure tricouche sont formées sur la même face du substrat.

D'après US-A-4 216 488 il est connu une autre structure de diac à électrodes coplanaires.

Plus précisément, l'invention propose une structure semiconductrice de diac, possédant deux électrodes et une caractéristique tension-courant présentant une zone de blocage et une zone de conduction, la zone de blocage s'étendant entre une tension nulle et une tension de seuil Vd, et la zone de conduction présentant une faible résistance dynamique négative immédiatement au delà de la tension de seuil Vd, cette structure comprenant d'un côté d'un substrat semiconducteur d'un premier type de conductivité à faible niveau de dopage des première et deuxième régions disjointes du premier type de conductivité (P) à niveau de dopage élevé, une troisième région et une quatrième région du type opposé (N) à haut niveau de dopage, respectivement adjacentes aux première et deuxième régions, les troisième et quatrième régions étant recouvertes de métallisations séparées constituant les électrodes de la structure formée sur ladite face du substrat, la couche du premier type de conductivité étant isolée de toute métallisation.

De préférence la couche du premier type de conductivité présente une partie de faible dopage et des parties plus dopées adjacentes aux régions du second type de conductivité et séparées par une région étroite de faible dopage.

D'autres caractéristiques et avantages de l'invention apparaîtront à la lecture de la description détaillée qui suit et qui est faite en référence aux dessins annexés dans lesquels :

la figure 1 représente un diac classique,

la figure 2 représente un diac selon un premier mode de réalisation de l'invention,

la figure 3 représente un diac selon un deuxième mode de réalisation de l'invention.

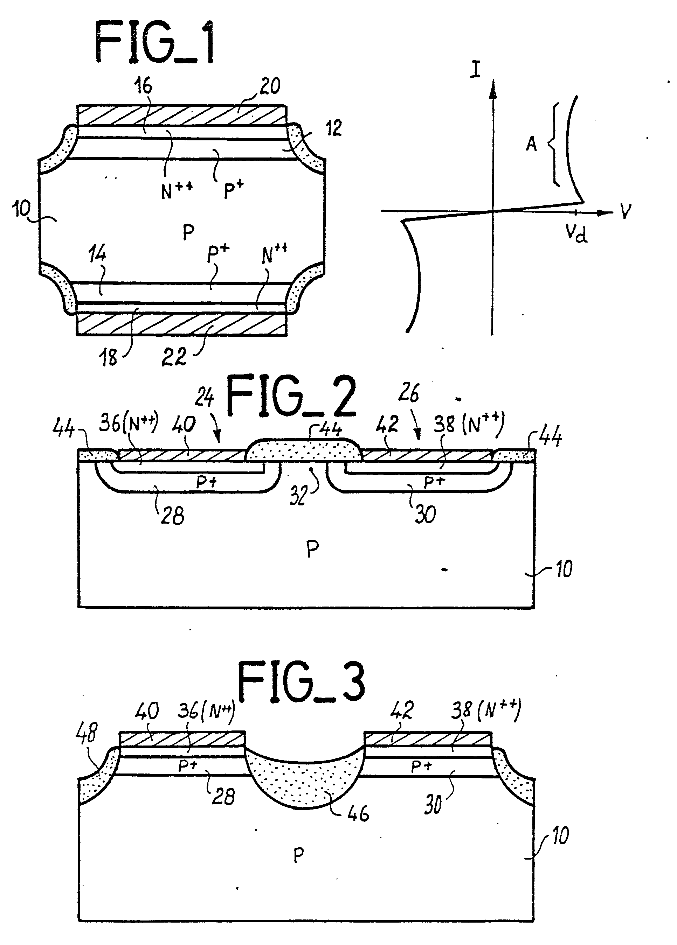

On rappelle pour mémoire à la figure 1 la structure d'un diac classique. La forme générale de la caractéristique tension-courant est représentée sur la même figure avec son seuil Vd, et sa portion A à faible résistance dynamique négative immédiatement au delà du seuil. Le diac est constitué par un substrat de base 10 de type P (diac NPN) dans lequel on a diffusé sur une face une région 12 plus dopée de type P⁺ et sur l'autre face une région 14 symétrique de la région 12 et de même profil de dopage. Des régions 16 et 18 de type opposé N⁺, fortement dopées, sont diffusées à partir de chaque face sur une partie de la profondeur des régions 12 et 14. La surface de ces régions 16 et 18 est métallisée pour constituer des électrodes 20 et 22 respectivement, chacune sur une face respective du substrat. Conformément à l'habitude dans ce domaine, les dimensions sont représentées avec des échelles arbitraires pour les différentes couches, afin de faciliter la représentation.

Les caractéristiques électriques (résistance dans l'état conducteur notamment) dépendent du dopage et de l'épaisseur de la couche 10 de type P.

Un premier mode de réalisation de l'invention est représenté à la figure 2.

On part toujours d'un substrat 10 de type P (par exemple), ou d'un substrat quelconque dans lequel on a formé une couche de type P. On forme sur la surface du substrat une couche d'oxyde de masquage 44 dans laquelle on ouvre, par gravure sélective, deux fenêtres 24 et 26 séparées par une région centrale d'oxyde. On diffuse dans ces fenêtres des régions 28 et 30 de même type de conductivité que le substrat mais plus dopés (P⁺). Les régions 28 et 30 restent séparées, au dessous de la région centrale de l'oxyde 44, par une zone 32 ayant la conductivité initiale du substrat. Puis, on diffuse à travers les mêmes fenêtres 24 et 26, moins profondément que les régions 28 et 30, des régions 36 et 38 de type de conductivité opposé, fortement dopées (N⁺⁺). Ces régions 36 et 38 affleurent sur une même surface du substrat et sont métallisées pour former deux contacts séparés 40 et 42 qui sont les électrodes du diac. L'oxyde 44 recouvre la zone 32 ainsi que l'affleurement des jonctions entre les régions 28 et 36 et entre les régions 30 et 38. Le dopage de type P des régions 28 et 30 est plus faible que le dopage de type N des régions 36 et 38 et il est choisi en fonction de la tension de seuil désirée pour le diac. Le franchissement du seuil (mise en conduction du diac) se fait normalement par avalanche dans la région de courbure d'une des jonctions N/P ainsi réalisées. Pour ajuster la tension de seuil du diac sans changer le dopage du substrat de départ, on joue sur la profondeur de diffusion des régions N à l'intérieur des régions P dont le profil de concentration est décroissant de la surface vers l'intérieur du substrat.

A la figure 3 un autre mode de réalisation est donné. Au lieu que les différentes jonctions entre régions N et P remontent vers la surface du substrat, elles arrivent horizontalement sur le bord d'un sillon 46 creusé dans le substrat à partir de sa surface, ce sillon ayant une profondeur supérieure à la profondeur des régions 36 et 38 de type $N^+$ et supérieure également à la profondeur des régions 28 et 30 de type $P^+$. Ce sillon est rempli d'isolant de passivation (verre) et c'est lui qui sépare la région 36 de la région 38 ainsi que la région 28 de la région 30. Par conséquent, les régions 28, 30, 36 et 38 n'ont pas besoin d'être formées par diffusion localisée : elles peuvent être réalisées par diffusion uniforme sur toute la surface du substrat. Le sillon 46 est creusé après cette diffusion uniforme et sépare les régions 28 et 30 pour réaliser une structure à trois régions $N^+$ P $N^+$ comme dans le cas des figures 1 et 2 avec un surdopage $P^+$ au niveau des jonctions entre les régions de type opposé. Ici, la mise en conduction du diac se fait par suite d'un claquage superficiel d'une jonction P/N entre la couche ou le substrat 30 et la région 28 ou 30 à l'endroit où cette jonction rencontre le sillon passivé 46 conductrice. Pour ajuster la tension de seuil du diac à une valeur désirée, il faut choisir convenablement la profondeur des régions 36 et 38, le profil de concentration 28 et 30 étant décroissant de la surface vers l'intérieur du substrat. Ainsi, la tension de seuil du diac ne dépend plus du substrat de départ. On réalise des métallisations 40 et 42 sur les régions 36 et 38, par exemple par trempage dans un bain chimique qui dépose du nickel sur le silicium mais non sur le verre de passivation prévu dans le sillon central 46 et dans un sillon périphérique 48.

L'encapsulation des dispositifs des figures 2 et 3 se fait par exemple dans un boîtier de résine moulée avec des barettes conductrices ou des fils d'aluminium soudés entre les surfaces métallisées 40 et 42 et des broches extérieures selon les techniques utilisées par exemple pour des thyristors. Le diac selon l'invention peut également être intégré dans un substrat semiconducteur comportant par ailleurs un autre composant tel qu'un triac par exemple.

## Revendications

1. Structure semiconductrice de diac, possédant deux électrodes (40, 42) et une caractéristique tension-courant présentant une zone de blocage et une zone de conduction, la zone de blocage s'étendant entre une tension nulle et une tension de seuil Vd, et la zone de conduction présentant une faible résistance dynamique négative immédiatement au delà de la tension de seuil Vd, cette structure comprenant d'un côté d'un substrat semiconducteur d'un premier type de conductivité à faible niveau de dopage (10) des première (28) et deuxième (30) régions disjointes du premier type de conductivité (P) à niveau de dopage élevé, une troisième région (36) et une quatrième région (38) du type opposé (N) à haut niveau de dopage, respectivement adjacentes aux première et deuxième régions, les troisième et quatrième régions étant recouvertes de métallisations séparées (40, 42) constituant les électrodes de la structure formée sur ladite face du substrat, la couche du premier type de conductivité étant isolée de toute métallisation.

2. Structure semiconductrice selon la revendication 1, caractérisée en ce que les jonctions entre la troisième région et la première région ainsi qu'entre la quatrième région et la deuxième région remontent à la surface du substrat et sont recouvertes d'une substance isolante (44) séparant les deux métallisations (40, 42).

3. Structure semiconductrice selon la revendication 1, caractérisée en ce que les jonctions entre la troisième région et la première région ainsi qu'entre la quatrième et la deuxième région sont planes et affleurent sur le flanc d'un sillon passivé (46) séparant les deux métallisations (40, 42).

4. Structure semiconductrice selon la revendication 1, caractérisée en ce que les première et deuxième régions (28, 30) ont un profil de concentration décroissant de la surface vers l'intérieur du substrat.

## Claims

1. A diac semiconductor structure, including two electrodes (40, 42) and a voltage-current characteristic having a blocking zone and a conducting zone, the blocking zone extending between zero voltage and a threshold voltage Vd, and the conducting zone having a low negative dynamic resistance immediately below the threshold voltage Vd, the structure comprising, on one side of a semiconductor substrate of a first type of conductivity with a low dopage level (10), first (28) and second (30) regions of the first type of conductivity (P) with a high dopage level, and a third region (36) and a fourth region (38) of the opposite type (N) with a high dopage level, respectively adjacent to the first and second regions, the third and fourth regions being covered by separate metallizations (40, 42) constituting the electrodes of the structure formed on the said surface of the substrate, the layer of the first type of conductivity being insulated from any metallization.

2. A semiconductor structure according to Claim 1, characterized in that the junctions between the third region and the first region, and also between the fourth region and the seocnd region extend upwardly to the surface of the substrate and are covered by an insulating substance (44) separating the two metallizations (40, 42).

3. A semiconductor structure according to Claim 1, characterized in that the junctions between the third region and the first region, and also between the fourth region and the second region are planar and are flush with the side of a passivated groove (46) separating the two metallizations (40, 42).

4. A semiconductor structure according to Claim 1, characterized in that the first and second regions (28, 30) have a concentration profile decreasing from the surface towards the interior of the substrate.

**Patentansprüche**

1. Diac-Halbleiterstruktur, die zwei Elektroden (40, 42) und eine Spannungs-Strom-Charakteristik besitzt, die einen Sperrbereich und einen Durchlaßbereich aufweist, wobei sich der Sperrbereich zwischen einer Nullspannung und einer Schwellenspannung Vd erstreckt und der Durchlaßbereich unmittelbar jenseits der Schwellenspannung Vd einen kleinen negativen dynamischen Widerstand besitzt, und wobei diese Struktur auf der einen Seite eines Halbleitersubstrates (10) eines ersten Leitungstyps mit niedriger Dotierung voneinander getrennt einen ersten (28) und einen zweiten (30) Bereich vom ersten Leistungstyp (P) mit erhöhter Dotierung und einen dritten Bereich (36) und einen vierten Bereich (38) vom entgegengesetzten Typ (N) mit hoher·Dotierung umfaßt, die an den ersten bzw. zweiten Bereich angrenzen, wobei der dritte und der vierte Bereich von getrennten Metallisierungen (40, 42) bedeckt sind, die die Elektroden der auf dieser Fläche des Substrates gebildeten Struktur bilden, und die Schicht vom ersten Leitungstyp von jeglicher Metallisierung isoliert ist.

2. Halbleiterstruktur nach Anspruch 1, dadurch gekennzeichnet, daß die Übergangszonen zwischen dem dritten Bereich und dem ersten Bereich ebenso wie zwischen dem vierten Bereich und dem zweiten Bereich zur Oberfläche des Substrates aufsteigen und von einer isolierenden Substanz (44) bedeckt sind, die die beiden Metallisierungen (40, 42) voneinander trennt.

3. Halbleiterstruktur nach Anspruch 1, dadurch gekennzeichnet, daß die Übergangszonen zwischen dem dritten Bereich und dem ersten Bereich ebenso wie zwischen dem vierten und dem zweiten Bereich eben sind und an der Flanke einer passivierten Rinne (46) zu Tage treten, die die beiden Metallisierungen (40, 42) voneinander trennt.

4. Halbleiterstruktur nach Anspruch 1, dadurch gekennzeichnet, daß der erste und der zweite Bereich (28, 30) ein Konzentrationsprofil aufweisen, das von der Oberfläche zum Inneren des Substrates hin abnimmt.

# FIG_1

# FIG_2

# FIG_3